# EUROPEAN PATENT APPLICATION

(11) **EP 4 579 732 A1**
(43) Date of publication of application: **02.07.2025**
(21) Application number: 24223219.7
(22) Date of filing: 24.12.2024
(51) Int. Cl.: H01L 23/373, H01L 23/495, H01L 23/433

(54) **PACKAGE, MANUFACTURING METHOD THEREOF AND ELECTRICAL SYSTEM**

(30) Priority: 29.12.2023 CN 202311862019; 16.12.2024 US 202419982683
(71) Applicant: Shenzhen STS Microelectronics Co., Ltd., Shenzhen 518048 (CN)
(72) Inventor: ZHENG, Nan Nan, SHENZHEN, 518038 (CN); CHEN, Qiao, SHENZHEN, 518040 (CN); FENG, Qing Ming, SHENZHEN, 518038 (CN)
(74) Representative: Casalonga

(57) **Abstract**

The present disclosure relates to package, manufacturing method, and electrical system. The package comprises: a mounting substrate with at least one power die having a power device and attached to a first surface of the mounting substrate; and a lead frame comprising a first die attachment portion and at least one first lead, wherein at least one cooperation device die having a cooperation device for cooperating with the power device is attached to the first die attachment portion, and wherein during a normal operation an amount of heat generated by the cooperation device is less than an amount of heat generated by the power device, wherein the at least one first lead is coupled to the first surface of the mounting substrate to be electrically coupled to the power die.

## Description

### Cross Reference to Related Application(s)

This application claims the priority benefit of Chinese Patent Application Number 202311862019.2, filed on December 29, 2023, entitled " Package, Manufacturing Method Thereof, And Electrical System", which is hereby incorporated by reference to the maximum extent allowable by law.

### Technical Field

This disclosure relates to a package, a manufacturing method (packaging method), and an electrical system comprising the package.

### Background

The Intelligent Power Module (IPM) is receiving more and more attentions. For IPM package with a mature design, it is a trend in package design to improve the performance by finely tuning the package design. On the other hand, expensive advanced substrates such as Direct Bond Copper (DBC) substrates are used for mounting power-side devices in IPM packages to improve heat dissipation performance, resulting in a significant increase in costs.

In addition, in conventional IPM packages, the sizes of the leads of the lead frame for connections with the DBC are mainly designed to ensure soldering strength of soldering processes (such as with solder paste), leading to a relatively large lead area. In addition, because of DBC layout constraints, the sizes of the leads may be not equal or similar, resulting in an uneven distribution of the leads. Therefore, there is a risk of overflowing of the mold compound at the backside of the DBC substrate during molding.

Therefore, there is a need to improve the packages and the manufacturing methods (packaging methods) in the prior art.

### Brief Summary

According to an aspect of the present disclosure, there is provided a A package comprising: a mounting substrate with at least one power die having a power device and attached to a first surface of the mounting substrate; and a lead frame comprising a first die attachment portion and at least one first lead, wherein at least one cooperation device die having a cooperation device for cooperating with the power device is attached to the first die attachment portion, and wherein during a normal operation an amount of heat generated by the cooperation device is less than an amount of heat generated by the power device, wherein the at least one first lead is coupled to the first surface of the mounting substrate so as to be electrically coupled to the power die.

According to another aspect of this disclosure, there is also provided an electrical system that may include the package according to any of the embodiments of the present disclosure.

According to another aspect of the present disclosure, there is also provided a method for manufacturing a package, comprising: attaching a power die to a first surface of a mounting substrate, the power die comprising a power device; attaching a cooperation device die to a first die attachment portion of a lead frame, the lead frame further comprising at least one first lead, the cooperation device die comprising a cooperation device that cooperates with the power device, wherein during a normal operation an amount of heat generated by the cooperation device is less than an amount of heat generated by the power device; attaching the at least one first lead to a first surface of the mounting substrate to be electrically coupled to the power die; performing wire bonding which comprises bonding a first wire to the power device and the cooperation device; and applying a mold compound to encapsulate at least a portion of the mounting substrate, the power die, the cooperation device die, the first wire, and at least a portion of the lead frame.

Other features and advantages of the present disclosure will become apparent from the following detailed description of exemplary embodiments of the present disclosure with reference to the accompanying drawings.

### Brief Description of the Drawings

The accompanying drawings, which are incorporated in and constitute a portion of this specification, illustrate embodiments of the present disclosure and, together with the description, serve to explain the principles of the present disclosure.

The present disclosure will be more clearly understood from the following detailed descriptions with reference to the accompanying drawings, in which:
FIG. 1 shows a schematic diagram of a conventional IPM package;
FIG. 2 shows a schematic diagram of a package according to some embodiments of the present disclosure;
FIG. 3 shows a schematic diagram of a package according to some embodiments of the present disclosure;
FIG. 4 shows a schematic diagram of a package according to some embodiments of the present disclosure;
FIG. 5 shows a perspective schematic diagram of a package according to some embodiments of the present disclosure;
FIG. 6 shows a schematic cross-sectional view of a package according to some embodiments of the present disclosure;
FIG. 7 shows a schematic cross-sectional view of a package according to some other embodiments of the present disclosure; and
FIG. 8 shows a flowchart of a packaging method according to some embodiments of the present disclosure.

Note that in the embodiments described below, same reference symbols are sometimes used among different drawings to indicate the same parts or parts with the same functions, and the repetitive explanations thereof will be omitted. In this specification, like or similar reference numerals and letters are employed to denote the like or similar items, and therefore, once an item is defined in a drawing, there is no need to provide further discussion on this item in the subsequent drawings.

For the sake of ease of understanding, the positions, dimensions, and ranges of the structures shown in the drawings may not necessarily represent the actual positions, dimensions, and ranges. Therefore, the disclosed disclosure shall not be limited to the positions, dimensions, and ranges or the like disclosed in the accompanying drawings or the like.

### Detailed Description

Various exemplary embodiments of the present disclosure will now be described in detail with reference to the accompanying drawings. Please note that, unless otherwise specified, the relative arrangement, numerical expressions and values of the components and steps set forth in these embodiments are not intended to limit the scope of the disclosure. Techniques, methods, and apparatuses known to those of ordinary skill in the relevant art may not be discussed in detail, but where appropriate, these techniques, methods, and apparatuses shall be considered as part of the specification.

It will be understood that the following description of at least one exemplary embodiment is merely illustrative and is not intended to limit the disclosure and its application or use in any sense. It should also be understood that any embodiment exemplarily described herein does not necessarily be preferred or advantageous over other embodiments. The disclosure is not intended to be limited by any expressed or implied theory presented in the preceding Technical Field, Background, Summary or the following detailed description.

Additionally, some certain terms may be used in the following description for reference purposes only, and therefore are not for purpose of limiting. For example, unless explicitly stated by the context, the terms "first", "second" and other such ordinal numerical terms referring to structures, elements, or the like do not indicate any sequence or order.

It will also be understood that the words "comprise", "include" or their variants, when being used herein, are intended to indicate that there is existence of a stated feature, integer, step, operation, element, and/or component, but does not preclude the presence or addition of one or more other features, integers, steps, operations, elements, and/or components and/or a combination thereof.

The term "chip" as used herein comprises, but is not limited to, die.

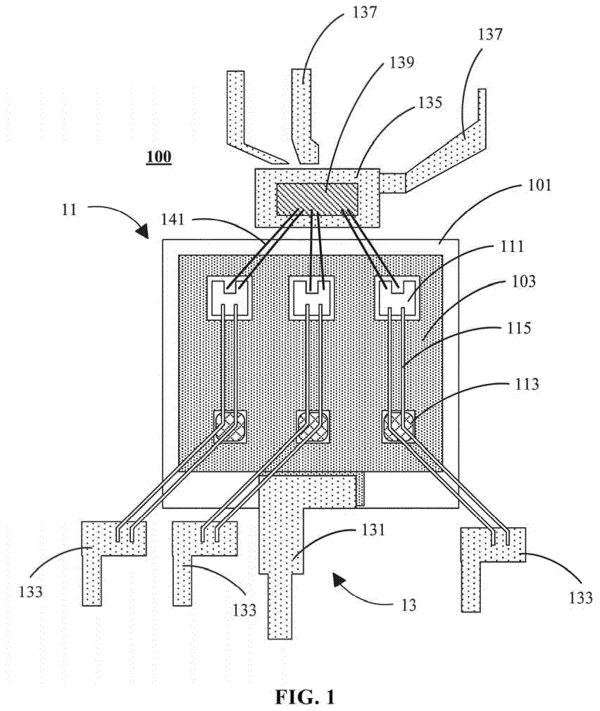

FIG. 1 shows a schematic top view of a conventional IPM package. It should be understood that some components in the figure are filled with shadows or patterns so as to be clearly distinguished from adjacent other components.

As shown in FIG. 1, a conventional IPM package 100 includes a mounting substrate 11 and a lead frame 13. Power dies 111 and cooperation device dies 113 that cooperate with the power dies are attached to the mounting substrate 11. The mounting substrate 111 may be, for example, a DBC substrate to provide good heat dissipation. The DBC substrate may include a ceramic layer 101 and metal layers on opposite sides of the ceramic layer. A metal layer 103 over the ceramic layer 101 is shown in the figure. The metal layer can be formed of, for example, copper or a copper alloy. The power dies 111 and the cooperation device dies 113 are attached and electrically coupled to the metal layer 103.

The power die 111 may be provided with a power device (not shown), such as but not limited to, an insulated gate bipolar transistor (IGBT). The cooperation device die 113 may be provided with a cooperation device (not shown) cooperating with the power device, such as but not limited to, a diode (also known as freewheel diode) that is coupled antiparallel with the IGBT. As an example, three power dies 111 and three corresponding cooperation device dies 11 are shown in the figure. The cooperation devices can be electrically coupled to the power dies (power devices) through, for example, wires 115 to form circuits.

The IMP package 100 can be divided into a power side (or power domain) and a control side (or control domain). In general, high voltage and large current are supplied at the power side; and lower voltage and current are supplied at the control side. The power devices and their cooperation devices are generally provided at the power side. Controller(s) for controlling the power devices are usually provided at the control side.

The lead frame 13 may include a metal, or in other words, may be form of a metal. For example, the metal may be a copper alloy including, but not limited to, binary, ternary, and quaternary copper-based alloys. The lead frame 13 may include a plurality of separate components. As shown in FIG. 1, the lead frame 13 includes leads 131 and 133. As shown in the figure, the lead 131 is attached to the metal layer 103 of the mounting substrate 101. The leads 133 are electrically coupled to respective power dies 111 and cooperation device dies 113 via wires 115.

The lead frame 13 may further include a die attachment portion 135, on which a controller chip 139 is provided. The controller chip 139 may provide control signals to the power dies 111 through wires 141. The lead frame 13 may also include leads 137 to electrically and physically couple the controller chip 139 to the external.

In the conventional design, both the IGBTs and the diodes are mounted on the DBC substrate so as to enhance their heat dissipation. Also, the DBC substrate accounts for a significant portion of the material cost of the IPM package (up to 45% in some cases), and is the main factor that affects the cost of IPM package.

The inventors of the present disclosure have found through their research that in an IPM package the heat is generated mainly by the power devices. Thus, the inventors of the present application proposed the disclosure disclosed herein through their research. According to embodiments of the present disclosure, the cost of the IPM package may be greatly reduced while still meeting the heat dissipation requirements. According to the embodiments of the present disclosure, one or more of the above problems with the conventional IPM package may be overcome. According to the embodiments of the present disclosure, the layout design of the DBC substrate can also be simplified.

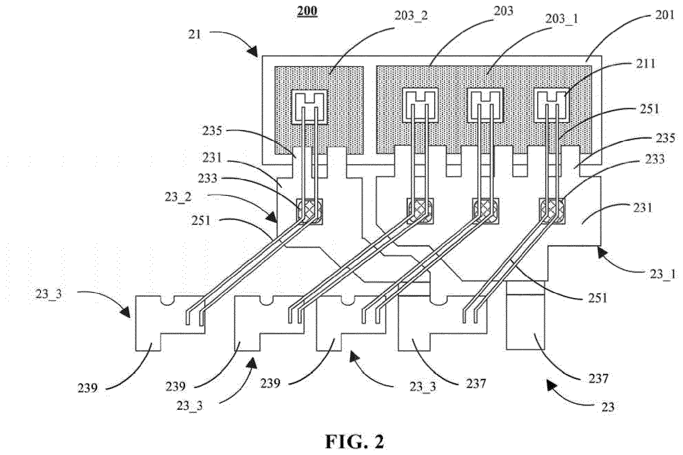

FIG. 2 shows a schematic diagram of a package according to some embodiments of the present disclosure. FIG. 2 shows a top view of some components of the package (here, some components at the power side). Note that in FIG. 2 and other top views, shadows or patterns are added to some components so as to more clearly distinguish them from other components.

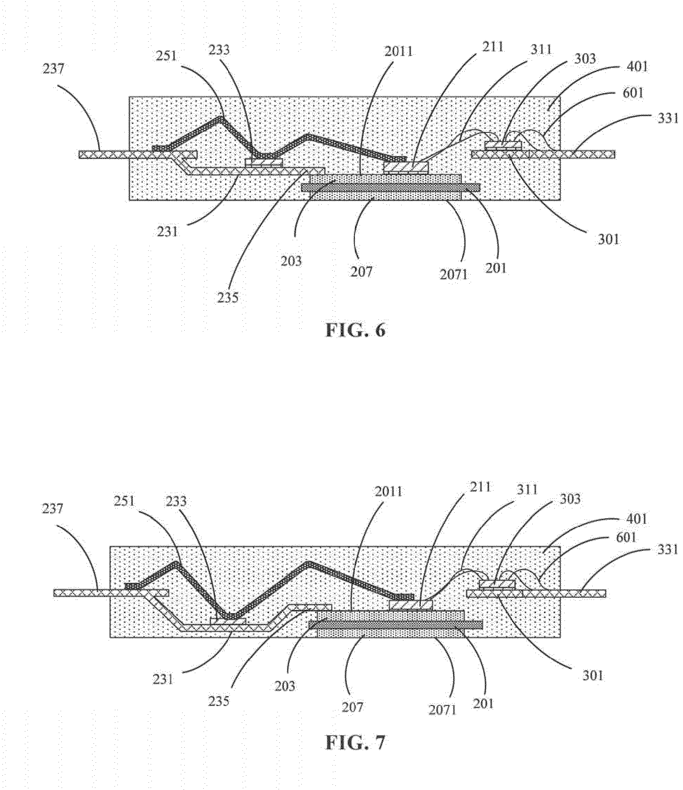

As shown in FIG. 2, a package 200 may include a mounting substrate 21 and a lead frame 23. At least one power die 211 is attached to a first surface (2011, FIG. 7) of the mounting substrate. Preferably, the mounting substrate 21 is a multi-layer substrate. As an example, the mounting substrate 21 may include one of the following: a DBC substrate, a Direct Plated Copper (DPC) substrate, an Active Metal Braze (AMB) substrate, a Direct Bonding Aluminum (DBA) substrate, or an Insulated Metal Substrate. As an example, a DBC substrate is employed as an example in the embodiment of FIG. 2. The mounting substrate 21 may include a first metal layer 203, a second metal layer 207 (see FIG. 7), and an insulation layer 201 sandwiched between the first and second metal layers. In the DBC substrate, the insulation layer 201 may be formed of a ceramic material, and the metal layers 203 and 207 may be formed of copper. In other embodiments, the metal layers of the mounting substrate may be formed of, for example, copper or aluminum.

The first metal layer 203 over the ceramic layer 201 may have one or more regions. Here, as an example, FIG. 2 shows two regions 203_1 and 203_2, over each of which one or more power dies 211 are provided. As shown in the figure, three power dies 211 are provided over the region 203_1 of the first metal layer, and one power die 211 is provided over the region 203_2. It should be understood that the first metal layer may have more or fewer regions.

The power die 211 may be attached (and thus electrically coupled) to a surface 2011 (see FIG. 7) of the first metal layer 203 by a solder material. The surface 2011 of the first metal layer 203 is here also referred to as a first surface of the mounting substrate. The power die may include power device(s), such as one or more of an insulated gate bipolar transistor (IGBT), an injection enhanced gate transistor (IEGT), an integrated gate commutated thyristor (IGCT), a thyristor, and a power Schottky diode, etc.

The lead frame 23 comprises a metal, or in other words, the lead frame may be formed of a metal. As an example, the metal may include copper, such as copper or an alloy containing copper. It should be understood that this disclosure shall not be limited thereto. The lead frame 203 may include first die attachment portion(s) 231 and at least one first lead 235. Cooperation device dies 233 are each attached to the respective first die attachment portions 231 by, for example, soldering with a solder. The cooperation device die includes a cooperation device such as a diode that cooperates with the power device. Descriptions will be given with examples in which the power device is an IGBT and the cooperation device is a diode. In such a case, the diode may be coupled in anti-parallel to the IGBT. When the IGBT is operating (i.e. a forward voltage is applied to the IGBT), a large current flows through the IGBT and the freewheeling diode is off (not working). Therefore, heat is generated mainly by the power device (IGBT). When there is a large reverse electromotive force, the diode is turned on and passes current to protect the power device (IGBT). Therefore, the amount of heat generated by cooperation device (diode) is less than that of the power device (IGBT).

The first leads 235 are bonded to a first surface of the mounting substrate 21 (here, the upper surface 2011 of the metal layer 203) and electrically coupled to the power dies. The first leads 235 may protrude and extend outward from an edge of the first die attachment portions 231. Preferably, the edges of the first leads 235 are straight. The adjacent edges of adjacent first leads 235 are configured to be straight and parallel to each other, and the gaps between the adjacent edges are configured to have the same width. Preferably, the first leads 235 may be bonded to the mounting substrate 21 by laser or ultrasonic bonding, thereby improving the bonding reliability. FIG. 2 shows six first leads 235 bonded to the region 203_1 of the first metal layer, and two first leads 235 bonded to the region 203_2 of the first metal layer. However, this is only illustrative and there may be more or fewer leads. In some embodiments, the lead frame 23 may also include additional leads, such as leads (second leads) 237 for electrical connections to other and/or external components of the package.

As shown in the figure, a plurality of first leads 235 are provided at an edge of the lead frame 23 facing the power dies and are evenly distributed at that edge. Therefore, the first leads are also evenly distributed on the mounting substrate 21 (specifically, on its metal layer 203). In this way, when the lead frame 23 is bonded to the mounting substrate 21, the mounting substrate 21 may be uniformly stressed and thus the possibility of the mounting substrate 21being displaced or tilted is reduced, thereby improving or even eliminating overflow of the mold compound to the backside of the DBC substrate.

Further, as shown in FIG. 2, the lead frame 23 may have a plurality of parts positioned separately from each other. As an example, FIG. 2 shows a part 23_1, a part 23_2, and a plurality of other parts 23_3. It should be understood that this is only illustrative. For example, the lead frame 23 may have only a part 23_1 or a part 23_2, or it may have more parts. As shown in the figure, the part 23_1 includes die attachment portion(s) 231, first lead(s) 235, and second lead(s) 237. Preferably, the die attachment portion 231 and the respective first leads 235 and second leads 237 are formed integrally. The part 23_2 is shown as separate from the part 23_1, and includes a die attachment portion 231, first leads 235, and additional leads (second leads 237) for electrical connection to an external and/or other part(s). In addition, other parts are also shown in FIG. 2, such as parts 23_3 which may include additional leads 239. Here, only portions of the parts 23_3 that include the leads (third leads) 239 are illustrated. However, it should be understood that the part 23_3 may also include other portions, such as a die attachment portion and/or first lead(s) arranged in the same or similar manner as the parts 23_1 and 23_2.

Here, it should also be understood that although the second leads 237 and the third leads 239 are shown and described as being used for electrical connection to the exterior in this embodiment, the present disclosure shall not be limited thereto. For example, in other embodiments, the second leads 237 and the third leads 239 may not be electrically coupled to the exterior. Furthermore, it should also be understood that the configurations of the first, second and third leads may be varied and that the positions, dimensions, shapes, numbers, etc. shown in the figures are merely illustrative.

As shown in the figure, wires (first wires) 251 are bonded to the power die 211 and the cooperation device die 233 to provide an electrical connection therebetween. Although not shown, it will be readily understood by those skilled in the art that dies (such as power dies, cooperation device dies, and controller chips which will be described below) may be provided with bond pads, and sections of the wires may be bonded to the bond pads to provide mechanical and electrical couplings. Preferably, the wires 251 are aluminum wires. However, this disclosure shall not be limited thereto. For example, copper wires may also be used. As an example, an electrode of an IGBT die (which serves as the power die) may be electrically coupled to the metal layer 203 (or a portion thereof) of the DBC substrate 21, and an electrode of a diode die (which serves as the cooperation device die) may be electrically coupled to the lead frame 23 (or a part thereof, such as 23_1), so that the IGBT die and the diode die both are electrically coupled to each other via the first leads. An end of the wire 251 may be electrically coupled to another electrode of the IGBT die, and the other end of the wire 251 may be electrically coupled to another electrode of the diode die, thereby forming an electrical connection therebetween. If required, the wire(s) 251 may be further bonded to a corresponding second lead or other part/component as shown in FIG. 2. It should also be understood that although two wires 251 are shown for each power die in the figure, this disclosure shall not be limited thereto.

In packages, the mounting substrate, such as a DBC substrate, has superior heat dissipation performance, but is expensive and constitutes a significant portion of the cost of the IPM packages. In packages, the heat dissipation performance of the lead frame may be lower than that of the mounting substrate due to encapsulation by the mold compound. For the applications of IPM packages and power devices, heat has a substantial impact on the performance of the power devices and even the entire package. Heat dissipation is therefore an important aspect in consideration. In the prior art, there was always a tendency to place the power-side electronic components onto a mounting substrate with better heat dissipation (such as a DBC substrate) to meet the heat dissipation requirements. The higher the voltage and current that the power devices may withstand, the more necessary it is.

After having conducted a fine analysis of the heat dissipation of the parts/components of the IPM packages in the related arts, it is recognized that the cooperation device die could be placed onto the lead frame while still meeting the heat dissipation requirements. In this way, the area of the expensive mounting substrate such as DBC substrate used may be greatly reduced, thereby greatly reducing the cost of the package. In some examples, the size of the DBC substrate can be reduced by up to 45.9 %, resulting in a significant reduction in packaging costs of the package modules while maintaining consistent heat dissipation for packaged products.

For example, the size of the DBC substrate may be 29 mm x 12 mm x 0.98 mm, the thickness of the lead frame may be 0.38 mm, and the size of the IGBT die may be 2.5 mm x (2.5 mm to 3.5 mm) x 4.8 mm. The size of the diode die may be 2.2 mm x 2.2 mm. According to the embodiments of the present disclosure, not only he area of the DBC substrate occupied by the diode die is eliminated, but also the IGBT die is allowed to be as close as possible to the first leads.

In addition, by removing the power-side cooperation device die from the mounting substrate, the layout design of the mounting substrate is more flexible and easier. Moreover, since the layout of the mounting substrate is simplified, the first leads can be designed to be smaller and more evenly distributed, making it suitable for the leads (and the lead frame) to be bonded to the mounting substrate by ultrasonic or laser welding, reducing the rate of bond failure between the lead frame and the mounting substrate, and improving product reliability.

In addition, compared to the prior art, in the embodiments of the present disclosure, the leads are more evenly distributed on the mounting substrate (e.g. a DBC substrate), thereby alleviating or eliminating issue of overflow of the mold compound to the backside of the DBC.

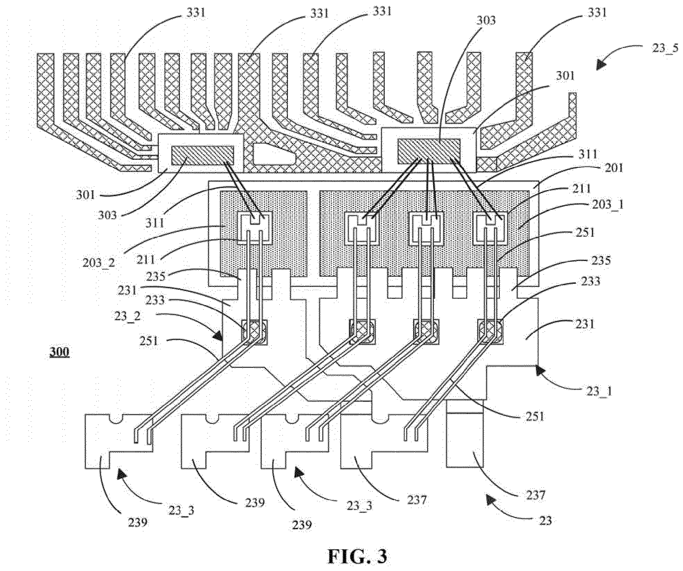

FIG. 3 shows a schematic top view of some parts/components (here, some power-side parts/components and some control-side parts/components) of the package according to some embodiments of the present disclosure. The package 300 shown in FIG. 3 essentially includes all parts of the package 200 shown in FIG. 2. In addition, the package 300 further includes some parts of the control side. As shown in FIG. 3, the lead frame 23 may also include an additional part 23_5 for the control side, which is positioned separately from the other parts 23_1, 23_2, 23_3, etc. The part 23_5 of the lead frame may include additional die attachment portions (second die attachment portions) 301 and additional leads (fourth leads) 331. The die attachment portions (second die attachment portions) 301 are also correspondingly positioned separately from the first die attachment portions 231 and the respective first leads 235 of the parts 23_1 and 23_2.

A controller chip 303 is provided over the die attachment portion 301 and is electrically coupled to the power die(s) through wire(s) (second wire) 311. Therefore, the controller chip 303 may provide signal(s) to the power dies to, for example, control the operation of the associated power devices. As an example, FIG. 3 illustrates two die attachment parts 301 and two controller chips 303. Preferably, the wires 311 are copper wires.

It should be understood that the configuration of the part 23_5 shown in FIG. 3 is only illustrative, and the present disclosure shall not be limited thereto. It should also be understood that the configuration of the third leads 331 may be varied. FIG. 3 shows different configurations of the third leads 331. Some leads 331 may be communicated to the die attachment portion 301, while the remaining leads 331 may be isolated from the die attachment portion 301. The control die 303 may be electrically coupled to the corresponding isolated leads through other wires (not shown in FIG. 3, for example, wires 601 in FIG. 6) .

Those skilled in the art would easily understand that in some intermediate products or intermediate manufacturing processes. one or more of the above parts 23_1, 23_2, 23_3, 23_5 of the lead frame 23 may be coupled to each other by, for example, tie bars (not shown in the figure) The tie bars may be removed after applying the mold compound, thereby separating the above parts from each other.

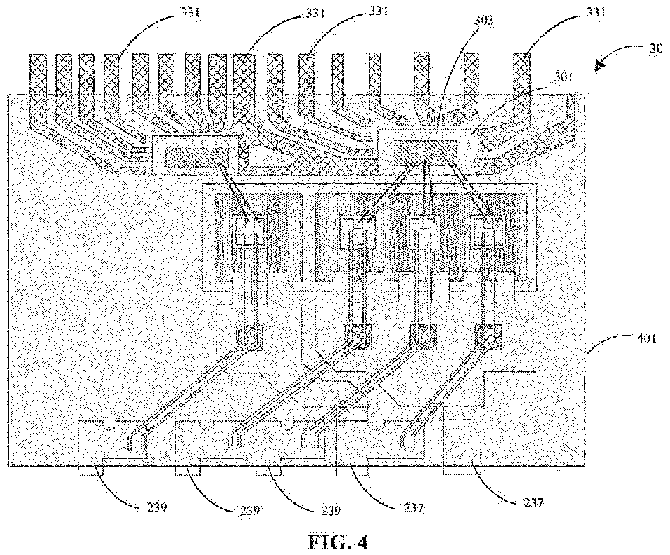

FIG. 4 shows a schematic top view of a package according to some embodiments of the present disclosure. The package shown in FIG. 4 essentially includes all parts of the package 300 shown in FIG. 3. The package further includes a mold compound 401. The mold compound 401 encapsulates at least a portion of the mounting substrate 21, the power dies 211, the cooperation device dies 233, the first wires 251, and at least a portion of the lead frame 23. In some embodiments, in the case where a DBC substrate is used as the mounting substrate 21, the mold compound may be configured to expose a second surface (2071 in FIG. 6 or FIG. 7) of the mounting substrate 21 opposite the first surface.

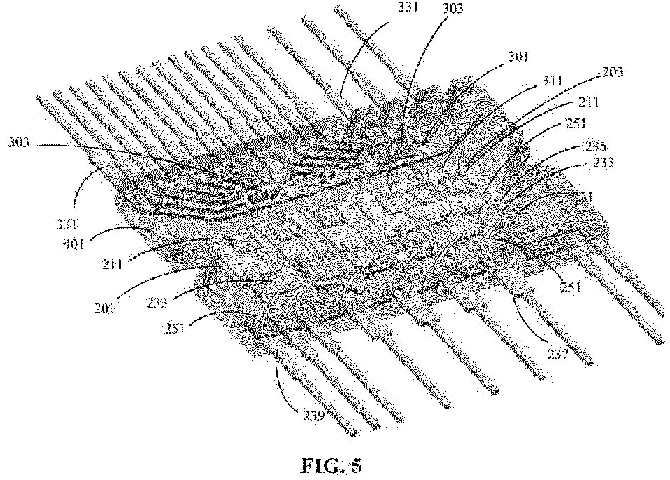

FIG. 5 shows a perspective simulation view of the package according to some embodiments of the present disclosure to assist in understanding of the planar top view described above. The elements in FIG. 5, which are the same as those in the previous figures, are labeled with the same reference signs as in the previous figures and will not be described repeatedly here.

FIG. 6 shows a schematic cross-sectional view of the package according to some embodiments of the present disclosure. The elements in FIG. 6, which are the same as those in the previous figures, are labeled with the same reference signs as in the previous figures and will not be described repeatedly here. In the embodiment shown in FIG. 6, the first die attachment portion 231 is arranged to be substantially flush with the first lead 235, while the second lead 237/third lead 239 is arranged higher than the corresponding first die attachment portion 231. The lead 237/239 is arranged to be substantially flush with the lead 331 on the opposite side. In this way, the height of the cooperation device die may be reduced (e.g. relative to the bottom surface of the package), leaving sufficient space for the formation of the wire 251 thereover. Furthermore, the lead configuration may be maintained the same as in the packages of the prior art.

In addition, since the first wire 251 protrudes above the mounting substrate 21 and the lead frame 23, the thickness of the mold compound and the height of the first wire should be selected to ensure that the mold compound is sufficient to cover the first wire (as well as other wires).

FIG. 7 shows a schematic cross-sectional view of a package according to other embodiments of the present disclosure. The elements in FIG. 7, which are the same as those in the previous figures, are labeled with the same reference signs as in the previous figures and will not be described repeatedly here. In the embodiment shown in FIG. 7, the first die attachment portion 231 is further lowered and configured to be lower than the first lead 235, while the lead 237/239 is configured to be higher than both the first die attachment portion 231 and the first lead 235. In this way, the height of the lead 251 may be further reduced, reducing the height (thickness) of the mold compound accordingly. On the other hand, the cooperation device die 233 may be located closer to the bottom surface of the package, thereby improving the heat dissipation of the cooperation device die 233.

As shown in FIGS. 6 and 7, the mounting substrate 21 may also include a second metal layer 207 disposed on the insulation layer (e.g. ceramic layer) 201opposite to the first metal layer 203. The first metal layer 203 and the second metal layer 207 are located on opposite sides of the insulation layer 201, respectively. The mold compound 401 may be configured to expose the surface 2071 of the second metal layer 207. The mold compound also encapsulates the second wire 311, as well as other wires (such as the wire 601 coupled between the control die 303 and the lead 331) .

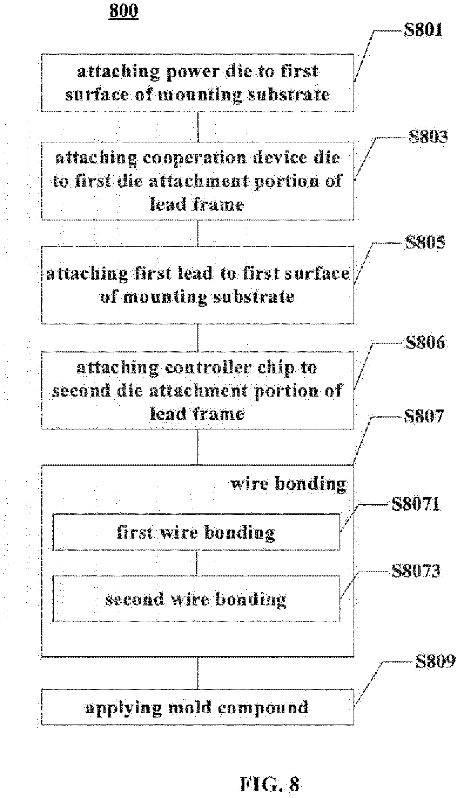

FIG. 8 shows a flowchart of a method for manufacturing a package according to some embodiments of the present disclosure. As shown in FIG. 8. the method 800 comprises, in step S801, attaching a power die to a first surface of a mounting substrate, wherein the power die comprises a power device. For example, the power die 211 may be attached to the first surface 2011 of the mounting substrate 21 by vacuum reflow soldering.

The method 800 further comprises, in step S803 attaching a cooperation device die to a first die attachment portion of a lead frame, wherein the lead frame further comprises at least one first lead. The cooperation device die includes a cooperation device that cooperates with the power device, wherein in normal operation the amount of heat generated by the cooperation device is less than that of the power device. For example, a cooperation device die 233 may be attached to a first die attachment portion 231 of the lead frame 23 by wire soldering.

The method 800 further comprises, in step S805, attaching the first lead to the first surface of the mounting substrate to electrically couple to the power die. For example, a mechanical support structure may be used to support the various parts of the lead frame. For example, tie bars may be used to couple the various parts of the lead frame, or the lead frame may be held by a clip, to attach the first lead 235 to the first surface 2011 of the mounting substrate 21 by laser or ultrasonic soldering so as to form an electrical connection with the power die 211.

The method 800 further includes performing wire bonding in step S807. The wire bonding includes bonding a first wire to the power die and the cooperation device die. For example, a first wire 251 may be bonded to the power die 211 and the cooperation device die 233 by aluminum wire bonding, so as to provide an electrical connection between the power die 211 and the cooperation device die 233. The first wire may be, for example, an aluminum wire.

The method 800 further comprises applying a mold compound in step S809. For example, a mold compound 401 is applied to encapsulate at least a portion of the mounting substrate 21, the power dies 211, the cooperation device dies 233, the first wires 251, and at least a portion of the lead frame 23 as shown in FIGS. 4, 6 and 7.

In some embodiments, after applying the mold compound, tie bars between the parts of the lead frame may be removed.

In some embodiments, the mounting substrate may include a first metal layer, a second metal layer, and an insulation layer sandwiched between the first and second metal layers. The power die is attached to a surface of the first metal layer which serves as a first surface of the mounting substrate. The lead frame may include a metal, such as copper.

In some embodiments, the lead frame may further include at least one second lead, wherein the at least one first lead, the first die attachment portion, and the at least one second lead are integrally formed. In some embodiments, the mold compound is further configured to expose a second surface of the mounting substrate opposite to the first surface.

In some embodiments, the heat dissipation performance of the lead frame is lower than that of the mounting substrate due to encapsulation by the mold compound. In some embodiments, the first die attachment portion is arranged to be substantially flush with the first lead. In other embodiments, the first die attachment portion is arranged lower than the first lead.

In some embodiments, the lead frame may include two or more first leads disposed at an edge of the lead frame facing the at least one power die, wherein the two or more first leads are arranged to be evenly distributed at the edge.

In some embodiments, the lead frame further comprises a third lead, which is positioned separately from a second die attachment portion and the second lead, and the first wire is also bonded to the third lead.

In some embodiments, the method 800 may further include, in step S806, attaching a controller chip to a second die attachment portion of the lead frame, wherein the second die attachment portion is positioned separately from the first die attachment portion and the first lead. For example, a controller chip 303 may be attached to the second die attachment portion 301 by adhesive bonding of silver paste.

There is no particular restriction on the order in which the steps S801, S803 and S806 are performed, as long as they are performed before the wire bonding step. For example, steps S801 and S803 may be performed simultaneously, which may save time in process. For another example, any one of steps S801, S803, and S806 may be performed before the other two.

In some embodiments, wire bonding further includes bonding a second wire to the controller chip and the power die. For example, a copper or gold wire (second wire) 311 may be bonded to the controller chip 301 and the power die 211 by copper or gold wire bonding. The mold compound 401 is further configured to encapsulate the second wire 311.

This application also contemplates an electrical system that may include a package according to any embodiments of the present disclosure. As an example, the electrical system may include, for example, an inverter, a new energy vehicle, a wind power system, a solar power generation system, an energy storage system, or any other device or system to which the package of the present disclosure may be applied.

This disclosure also contemplates the following items.

Item 1: A package comprising: a mounting substrate with at least one power die having a power device and attached to a first surface of the mounting substrate; and a lead frame comprising a first die attachment portion and at least one first lead, wherein at least one cooperation device die having a cooperation device for cooperating with the power device is attached to the first die attachment portion, and wherein during a normal operation an amount of heat generated by the cooperation device is less than an amount of heat generated by the power device, wherein the at least one first lead is coupled to the first surface of the mounting substrate and electrically coupled to the power die.

Item 2. The package according to item 1, wherein: the mounting substrate comprises a first metal layer, a second metal layer, and an insulation layer sandwiched between the first and second metal layers, the at least one power die being attached to a surface of the first metal layer, which serves as the first surface of the mounting substrate; and the lead frame comprises a metal.

Item 3. The package according to item 1, wherein: the lead frame further comprises at least one second lead for being electrically coupled to the external of the package, and the at least one first lead, the first die attachment portion, and the at least one second lead are integrally formed.

Item 4. The package according to any one of items 1 to 3, wherein: in the package, a heat dissipation performance of the lead frame is lower than that of the mounting substrate.

Item 5. The package according to item 1, wherein: the package is an IPM package, the mounting substrate comprises one of a DBC substrate, a DPC substrate, an AMB substrate, a DBA substrate, and an IMS substrate; the power device comprises one or more of an IGBT, an IGET, an IGCT, a thyristor, a power Schottky diode; the cooperation device comprises a diode.

Item 6. The package according to item 1, wherein the first die attachment portion is configured to: be substantially flush with the first lead; or be lower than the first lead.

Item 7. The package according to item 3, wherein the at least one second lead is configured to be higher than the first die attachment portion and the at least one first lead.

Item 8. The package according to item 1, further comprising: a first wire attached to the power die and the cooperation device die; and a mold compound encapsulating at least a portion of the mounting substrate, the power die, the cooperation device die, the first wire, and at least a portion of the lead frame, wherein the mold compound is configured to expose a second surface of the mounting substrate opposite to the first surface.

Item 9. The package according to item 1, wherein: the at least one first lead is arranged at an edge of the lead frame facing the at least one power die, and comprises two or more first leads, and the two or more first leads are arranged to be evenly distributed at the edge.

Item 10. The package according to item 8 further comprising: a controller chip for controlling the power device, wherein the controller chip is provided on a second die attachment portion of the lead frame and electrically coupled to the power die via a second wire, the second die attachment portion being positioned separately from the first die attachment portion and the at least one first lead, and wherein the mold compound further encapsulates the second wire.

Item 11. The package according to item 8, wherein: the lead frame further comprises a third lead, which is positioned separately from the first die attachment portion and the first lead, for being electrically coupled to the external of the package, and wherein the first wire is attached to the third lead.

Item 12. An electrical system comprising the package of any one of items 1 to 11.

Item 13. A method for manufacturing a package, comprising: attaching a power die to a first surface of a mounting substrate, the power die comprising a power device; attaching a cooperation device die to a first die attachment portion of a lead frame, the lead frame further comprising at least one first lead, the cooperation device die comprising a cooperation device that cooperates with the power device, wherein during a normal operation an amount of heat generated by the cooperation device is less than an amount of heat generated by the power device; attaching the at least one first lead to a first surface of the mounting substrate to be electrically coupled to the power die; performing wire bonding which comprises bonding a first wire to the power device and the cooperation device; and applying a mold compound to encapsulate at least a portion of the mounting substrate, the power die, the cooperation device die, the first wire, and at least a portion of the lead frame.

Item 14. The method according to item 13, wherein: the mounting substrate comprises a first metal layer, a second metal layer, and an insulation layer sandwiched between the first and second metal layers, the at least one power die being attached to a surface of the first metal layer, which serves as a first surface of the mounting substrate; the lead frame comprises a metal; the lead frame further comprises at least one second lead, wherein the at least one first lead, the first die attachment portion, and the at least one second lead are integrally formed; and the mold compound is configured to expose a second surface of the mounting substrate opposite to the first surface.

Item 15. The method according to item 13, wherein a heat dissipation performance of the lead frame is lower than that of the mounting substrate, when encapsulated by the applied mold compound.

Item 16. The method according to item 13, wherein the first die attachment portion is configured to: be substantially flush with the first lead; or be lower than the first lead.

Item 17. The method according to item 13, wherein the at least one first lead is arranged at an edge of the lead frame facing the at least one power die, and comprises two or more first leads, and the two or more first leads are arranged to be evenly distributed at the edge.

Item 18. The method according to item 13, wherein the lead frame further comprises a third lead, which is positioned separately from a second die attachment portion and a second lead, and wherein the first wire is further bonded to the third lead, the method further comprising: attaching a controller chip to a second die attachment portion of the lead frame, the second die attachment portion being positioned separately from the first die attachment portion and the first lead, wherein the wire bonding further comprises bonding the second wire to the controller chip and the power die, and wherein the mold compound further encapsulates the second wire.

Item 19. The method according to item 13, wherein the package is an IPM package, the mounting substrate comprises one of a DBC substrate, a DPC substrate, an AMB substrate, a DBA substrate, and an IMS substrate; the power device comprises one or more of an IGBT, an IGET, an IGCT, a thyristor, a power Schottky diode; and the cooperation device comprises a diode.

Those skilled in the art will recognize that the boundaries between the above-described operations (or steps) are merely illustrative. Multiple operations may be combined into a single operation, a single operation may be distributed in additional operations, and the execution of the operations may at least partially overlap in time. Moreover, alternative embodiments may include multiple instances of a particular operation, and the order of operations may be altered in other embodiments. Rather, other modifications, changes and substitutions are also possible. Accordingly, the specification and drawings are to be regarded as illustrative rather than restrictive.

Although some specific embodiments of the present disclosure have been described in detail by way of example, those skilled in the art should understand that the above examples are only for the purpose of illustration and are not intended to limit the scope of the present disclosure. The various embodiments disclosed herein may be combined arbitrarily without departing from the spirit and scope of this disclosure. Those skilled in the art should also understand that modifications may be made to the embodiments without departing from the scope and spirit of the present disclosure. The scope of the disclosure is defined by the following claims.

## Claims

1. A package comprising:
a mounting substrate with at least one power die having a power device and attached to a first surface of the mounting substrate;
a lead frame comprising a first die attachment portion and at least one first lead, wherein at least one cooperation device die having a cooperation device for cooperating with the power device is attached to the first die attachment portion, and wherein during a normal operation an amount of heat generated by the cooperation device is less than an amount of heat generated by the power device; and
wherein the at least one first lead is coupled to the first surface of the mounting substrate to be electrically coupled to the power die.

2. The package of claim 1, wherein the mounting substrate comprises a first metal layer, a second metal layer, and an insulation layer sandwiched between the first and second metal layers, the at least one power die being attached to a surface of the first metal layer, which serves as the first surface of the mounting substrate; and the lead frame comprises a metal.

3. The package of claim 1, wherein the lead frame further comprises at least one second lead for being electrically coupled to the external of the package; and
wherein the at least one first lead, the first die attachment portion, and the at least one second lead are integrally formed.

4. The package of claim 1, wherein in the package, a heat dissipation performance of the lead frame is lower than that of the mounting substrate.

5. The package of claim 1, wherein the package is an IPM package, the mounting substrate comprises one of a DBC substrate, a DPC substrate, an AMB substrate, a DBA substrate, and an IMS substrate, the power device comprises one or more of an IGBT, an IGET, an IGCT, a thyristor, a power Schottky diode, and the cooperation device comprises a diode.

6. The package of claim 1, wherein the first die attachment portion is configured to:
be substantially flush with the at least one first lead; or
be lower than the at least one first lead.

7. The package of claim 3, wherein the at least one second lead is configured to be higher than the first die attachment portion and the at least one first lead.

8. The package of claim 1, further comprising:
a first wire attached to the power die and the cooperation device die;
a mold compound encapsulating at least a portion of the mounting substrate, the power die, the cooperation device die, the first wire, and at least a portion of the lead frame; and
wherein the mold compound is configured to expose a second surface of the mounting substrate opposite to the first surface.

9. The package of claim 1, wherein the at least one first lead is arranged at an edge of the lead frame facing the at least one power die, and comprises two or more first leads; and
wherein the two or more first leads are arranged to be evenly distributed at the edge.

10. The package of claim 8 further comprising:
a controller chip for controlling the power device;
wherein the controller chip is provided on a second die attachment portion of the lead frame and electrically coupled to the power die via a second wire, the second die attachment portion being positioned separately from the first die attachment portion and the at least one first lead; and
wherein the mold compound further encapsulates the second wire.

11. The package of claim 8, wherein the lead frame further comprises a third lead, which is positioned separately from the first die attachment portion and the at least one first lead, for being electrically coupled to the external of the package, and wherein the first wire is attached to the third lead.

12. An electrical system comprising the package of claim 1.

13. A method for manufacturing a package, comprising:
attaching a power die to a first surface of a mounting substrate, the power die comprising a power device;
attaching a cooperation device die to a first die attachment portion of a lead frame, the lead frame further comprising at least one first lead, the cooperation device die comprising a cooperation device that cooperates with the power device, wherein during a normal operation an amount of heat generated by the cooperation device is less than an amount of heat generated by the power device;
attaching the at least one first lead to a first surface of the mounting substrate to be electrically coupled to the power die;
performing wire bonding which comprises bonding a first wire to the power device and the cooperation device; and
applying a mold compound to encapsulate at least a portion of the mounting substrate, the power die, the cooperation device die, the first wire, and at least a portion of the lead frame.

14. The method of claim 13, wherein the mounting substrate comprises a first metal layer, a second metal layer, and an insulation layer sandwiched between the first and second metal layers, the at least one power die being attached to a surface of the first metal layer, which serves as a first surface of the mounting substrate;
wherein the lead frame comprises a metal;
wherein the lead frame further comprises at least one second lead, wherein the at least one first lead, the first die attachment portion, and the at least one second lead are integrally formed; and
wherein the mold compound is configured to expose a second surface of the mounting substrate opposite to the first surface.

15. The method of claim 13, wherein the lead frame has a heat dissipation performance lower than that of the mounting substrate, when encapsulated by the applied mold compound.

16. The method of claim 13, wherein the first die attachment portion is configured to:
be substantially flush with the at least one first lead; or
be lower than the at least one first lead.

17. The method of claim 13, wherein the at least one first lead is arranged at an edge of the lead frame facing the at least one power die, and comprises two or more first leads; and
wherein the two or more first leads are arranged to be evenly distributed at the edge.

18. The method of claim 13, wherein the lead frame further comprises a third lead, which is positioned separately from a second die attachment portion and a second lead, and wherein the first wire is further bonded to the third lead, the method further comprising:
attaching a controller chip to a second die attachment portion of the lead frame, the second die attachment portion being positioned separately from the first die attachment portion and the at least one first lead;
wherein the wire bonding further comprises bonding a second wire to the controller chip and the power die; and
wherein the mold compound further encapsulates the second wire.

19. The method of claim 13, wherein the package is an IPM package, the mounting substrate comprises one of a DBC substrate, a DPC substrate, an AMB substrate, a DBA substrate, and an IMS substrate; the power device comprises one or more of an IGBT, an IGET, an IGCT, a thyristor, a power Schottky diode; and
wherein the cooperation device comprises a diode.
